# EUROPEAN PATENT APPLICATION

(11) **EP 0 653 782 A2**
(43) Date of publication of application: **17.05.1995**
(21) Application number: 94117441.9
(22) Date of filing: 04.11.1994
(51) Int. Cl.: H01L 21/3105, H01L 21/316, B05D 3/00, C03B 33/02

(54) **Method for reforming insulating film**

(30) Priority: 10.11.1993 JP 281158/93
(71) Applicant: CANON SALES CO., INC., Minato-ku, Tokyo 108 (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo c/o Semiconductor Process Lab.Co,Ltd, Minato-ku, Tokyo (JP); Yuyuma, Yoshiaki c/o Semiconductor Process Lab., Minato-ku, Tokyo (JP); Tokumasu,Noboru, c/o Semiconductor Process, Minato-ku, Tokyo (JP)
(74) Representative: Schwabe - Sandmair - Marx

(57) **Abstract**

A method for reforming insulating film such as a BSG film formed by CVD technique. The method makes it an object to reduce the parasitic capacitance between conductor layers between which an insulating film, especially a BSG film, intervenes and includes the steps of depositing a BSG film 14 on a substrate 1 using a depositing gas and exposing the BSG film 14 to a reforming gas.

## Description

### BACKGROUND OF THE INVENTION

### 1. Field of the Invention

The invention relates to a method for reforming insulating borosilicate glass film (hereinafter, referred to as "BSG film") formed by a CVD technique.

### 2. Description of the Prior art

Most of inter-layer insulating films used for semiconductor devices are of SiO₂ or SiO₂-based materials. Such insulating films of SiO₂ system have a relative permittivity of 4.0 (measured at a frequency of 1 MHz). And the capacitance between the conductor layers which an insulating film is held between is thereby determined according to the equation:

$\text{C = ε₀·ε·A/t}$

where
ε₀ = the permittivity of the vacuum
ε = relative permittivity of the insulating film
A = the area of the facing or overlapping parts of conductor layers between which the insulating film intervenes, for computational reasons. However, contributions from other parts except for the facing or overlapping parts of the conductor layers should be taken into account in fact.
t = distance between the conductor layers between which the insulating film intervenes
Though such parasitic capacitance as stated above is inevitable in any semiconductor device, an excessively large value of parasitic capacitance will result in crosstalk between conductor layers or delay of signal propagation. Particularly, when a multi-layer metalization structure is used in order to improve an integration level of a semiconductor device, overlapping or facing areas of conductors are increased. This increase results in increase of the parasitic capacitance . Also, the smaller the scale of patterns is, the smaller the spacing between adjacent conductors is. In case that the spacing between adjacent conductors becomes smaller than that between the upper and lower conductors, the parasitic capacitance will increase so considerably as to produce a significant effect on the device characteristic .

One of the approaches to the reduction of the parasitic capacitance is to reduce relative permittivity (ε) of the insulating films between the conductor layers. For this purpose, the following measures have been taken so far.
(1) Use of SiO₂ films containing Si-F bonds or F. In case that the films are formed by hydrolysis of organic silicon compound containing F, 3.7 is obtained as ε of the films reportedly. Also, in another case that the silicon oxide film containing F is formed by means of a plasma CVD technique using a gas mixture consisting of C₂F₆ and TEOS (tetraethyl orthosilicate), a low relative permittivity is achieved reportedly.
(2) Use of organic resin films. A value of ε less than 3.0 is reported.
(3) Use of insulating films of Teflon system. A value of ε less than 3.0 is reported.
(4) Use of SiBN films or SiOBN films. An example in which the films are formed by sputtering is reported.

However, in case of (1), it has not yet been sufficiently clear what kind of bad effects on the device characteristics are exerted by the use of insulating films containing Si-F bonds or F.

In case of (2) and (3), the insulating films comprise substance completely different from SiO₂. It is doubtful whether or not such insulating films are practical.

Also, in case of (4), since the insulating films are not stable, they are not suitable for applications to semiconductor devices.

### SUMMARY OF THE INVENTION

It is an object of the invention to provide a method for reforming insulating films whereby it is capable of reducing the parasitic capacitance between the conductor layers between which an insulating film, especially BSG film intervenes.

Attention of the inventors was paid to other materials of SiO₂ system, especially BSG films except for SiO₂ materials containing Si-F bonds or F (because the effect of containing Si-F bonds or F on the device characteristics has not yet been sufficiently clear). The inventors investigated using these films how to reform the films to reduce the relative permittivity.

As a result of investigations, it has been found that there are correlation between the quantity of moisture in a borosilicate glass (BSG) film and the relative permittivity. For example, the BSG film increases in the relative permittivity after they have been left in the air. This suggests that the increase of the relative permittivity is related to the increase of the quantity of moisture contained in the BSG film, that is, the relative permittivity can be reduced by reducing the quantity of moisture in the BSG film.

Through investigations, it is found that the exposure of the BSG film to a plasma of a reforming gas such as oxygen, ammonia or inert gas leads to reduction of the quantity of moisture contained in the BSG film, whereby resulting in a reduction of the relative permittivity of the films. It is also found that a change on standing in the quantity of moisture in the BSG film becomes extremely small after exposure to a plasma.

According to the inventive method of reforming insulating films, the performance of BSG films is improved by exposing BSG films to a plasma of a reforming gas so that the relative permittivity is reduced through decreasing the quantity of moisture contained in the BSG films, and the BSG film after exposing are prevented from absorbing moisture.

Also, elevating a substrate temperature during exposure to a plasma increases the effect of reforming the film. Additionally, this plasma processing also works in processing an interlayer insulating film for covering an interconnection layer of Al etc., because a low temperature less than 500°C is enough for reforming.

Particularly, in case that the plasma processing of the invention is applied to a BSG film which has been formed using a gas mixture consisting of organic metal compound containing Si-O-B bonds and ozone as a depositiNG gas, the effect of a reduction in the relative permittivity of the BSG film increases. This is because Si-O-B bonds has been introduced into the BSG film as they are as components just after deposition of it and the BSG film has high denseness and low hygroscopicity.

Moreover, since a BSG film which contains Si-O-B bonds immediately after deposition can be formed even when the depositing temperature is as low as 400°C or lower, the application to semiconductor devices is possible without restriction in a manufacturing process.

Besides, it should be noted that the boron content of the BSG film can be finely adjusted by existence of tetraethyl orthosilicate in a depositing gas.

### BRIEF DESCRIPTION OF THE DRAWINGS

FIG. 1 is a sectional view illustrating a method for reforming BSG films according to an embodiment of the invention;
FIGs. 2(a) through (d) are sectional views illustrating a process of the deposition and the reforming of BSG films according to an embodiment of the invention;
FIG. 3 is a characteristic diagram showing a deposition rate of the BSG film formed by a CVD technique using a gas mixture consisting of SiOB source and O₃ with respect to the substrate temperature according to an embodiment of the invention;
FIG. 4 is a characteristic diagram showing a deposition rate of the BSG film formed by a CVD technique using a gas mixture consisting of SiOB source and O₃ with respect to the flow rate of a SiOB source gas according to an embodiment of the invention;
FIG. 5 is a characteristic diagram showing how the moisture content of the BSG film just after deposition depends on the additive ratio of O₃ in O₂ and showing the moisture content of the BSG film after plasma treatment according to an embodiment of the invention;
FIG. 6 is a characteristic diagram showing a change on standing in the moisture content of the BSG film due to exposure to the air after plasma treatment according to an embodiment of the invention;
FIG. 7 is a characteristic diagram showing a change on standing in stress in the BSG film due to exposure to the air after plasma treatment according to an embodiment of the invention;
FIG. 8 is a diagram illustrating exemplary SiOB source gases according to embodiments of the invention.

### DESCRIPTION OF THE PREFERRED EMBODIMENT

### (1) A method for reforming BSG films according to an embodiment of the invention

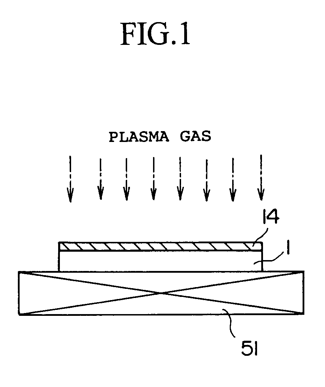

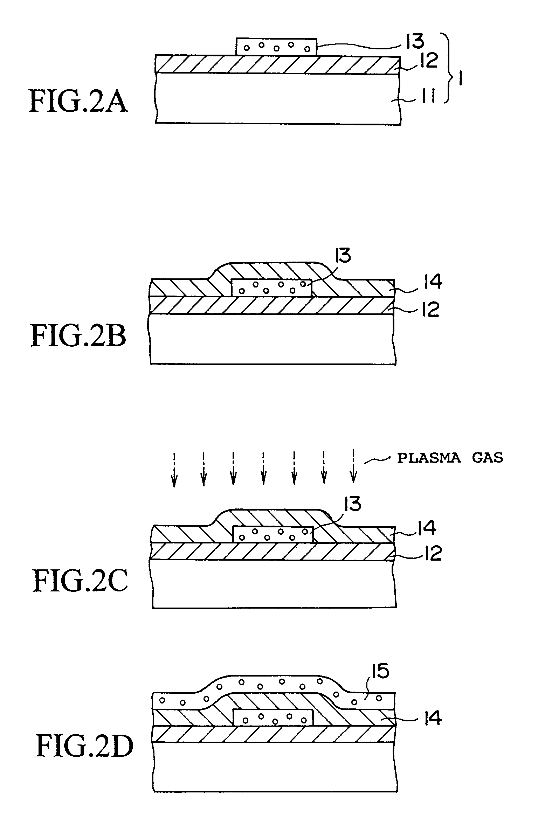

A method for reforming BSG films according to an embodiment of the invention is explained referring to FIG. 1 and FIG. 2(a) through 2(d).

FIG. 1 is a sectional view showing a state in which a BSG film is exposed to a plasma of a reforming gas. FIGs. 2(a) through 2(d) are sectional views illustrating a series of steps of forming a BSG film 14 as an interlayer insulating film covering a lower conductor layer 13, and reforming it by plasma irradiation.

In these cases, a gas containing an organic metal compound of silicon (Si), boron (B) and oxygen (O), (hereinafter, referred to as an SiOB source), is used as a depositing gas.

The following is available as the SiOB source. It is, for example, an organic metal compound with Si-O-B bonds which is represented by a general formula:

[R¹³-Si-O]ₙ-B-(OR²)₃₋ₙ,

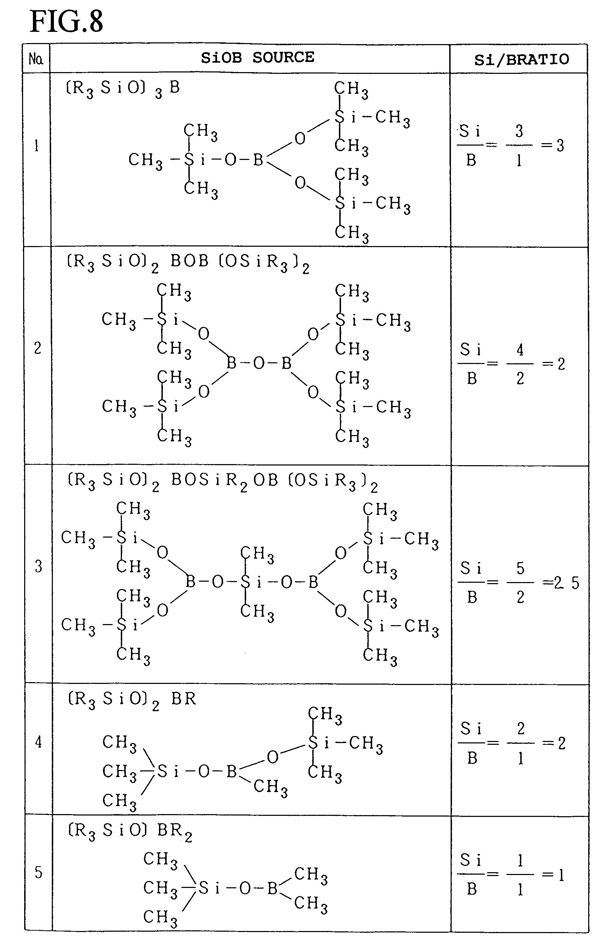

where n = 1, 2,..., and each of R¹ and R² denotes the alkyl group, aryl group or any organic group analogous to the foregoings. An alkyl group is an atomic group remaining when a hydrogen atom has been removed from a paraffin hydrocarbon. It is represented by the general formula of CₙH₂ₙ₊₁. A methyl group (CH₃) and an ethyl group (C₂H₅) are two of the examples. Also, an aryl group is a general term for a group remaining when a hydrogen atom has been removed from a aromatic hydrocarbon, and a phenyl group (C₆H₅-) is one of the examples. FIG. 8 shows exemplary SiOB sources.

Particularly, selecting tristrimethylsilylborate represented by the structural formula:

[(CH₃)₃SiO]₃B

among the above mentioned organic metal compound, a gas mixture consisting of the selected one and ozone (O₃):

[(CH₃)₃SiO]₃B + O₃

is used as a depositing gas.

First, a wafer (substrate) 1 is placed on a wafer holder in a reaction chamber of an atmospheric pressure CVD system and is heated, for example, by a built-in heater within the wafer holder so as to be kept at a temperature under 400°C. As shown in FIG. 2(a), the wafer 1 is provided by forming a insulating film 12 consisting of silicon oxide film on a semiconductor substrate 11 and further forming a lower conductor layer 13 consisting of an Al film on the insulating film 12.

Then, a depositing gas is introduced into the reaction chamber. The depositing gas is a mixture of SiOB source gas and O₃ gas. The SiOB source gas is consisting of a carrier gas such as N₂ containing [(CH₃)₃SiO]₃B and is passed at 7 SLM. O₃ gas is at an additive ratio of 6 % in O₂.

By maintaining this condition for 3 minutes, a BSG film 14 with a thickness of 1.1 µm is deposited on the wafer 1 as shown in FIG. 2(b). Since the then temperature of the wafer 1 is at 400°C or lower, it is possible to deposit an interlayer insulating film on a lower conductor layer 13 of Al film without letting the Al film suffer large thermal distortions.

Next, the wafer on which a BSG film 14 has been deposited is set on a wafer holder 51 shown in FIG. 1 in a chamber of a parallel plate plasma CVD system. The pressure in the chamber being reduced, the wafer 1 is heated by a heater installed in the wafer holder 51 so as to be kept at 500°C or lower. After a reforming gas of at least one selected from a group consisting of oxygen, ammonia or inert gas has been introduced into the chamber at a predetermined flow rate to maintain the pressure at about 1.0 Torr or lower, an RF power below 600 W and at a frequency from 100 KHz to 13.56 MHz is applied between the parallel plates to make the reforming gas into plasma. Thus, the BSG film 14 is exposed to the plasma of the reforming gas as shown in FIG. 2(c). After keeping this condition for 1 through 5 minutes, the BSG film is reformed to be reduced in its relative permittivity.

Then, an upper conductor layer 15 of an Al film etc. is further formed on the BSG film 14 as shown in FIG. 2(d).

Hereinafter, experimental results of performance and other characteristics of the BSG film 14 are explained. The BSG film 14 has been formed using a gas mixture of an SiOB source and O₃ but has not processed yet with a plasma.

There were 15 through 18 mol % (equivalent to 5 through 6 wt.%) of boron contained in the BSG film 14 formed as described above. The Si/B ratio of the SiOB source was 3, and the B content of the BSG film 14 was nearly equal to the theoretical value.

Thus, the B content of a BSG film 14 is substantially determined by the Si/B ratio of a SiOB source, whereby B can be controllably doped with a precise concentration. It is noted that further fine adjustment of the B content is also achieved by adding TEOS to the above mentioned depositing gas.

A BSG film formed by a conventional deposition method would have notably absorbed moisture immediately after deposition to have a cloud on its surface, whereas in case of the embodiment the BSG film was so stable that its moisture absorption was not observed while it was exposed to the air for a short time. Even after the BSG film had been exposed to the air for a long time, no change was observed on the surface of the film. This is because firm Si-O-B bonds are formed in the BSG film to improve the denseness of the film and thereby the absorption of moisture is prevented.

A BSG film 14 according to the embodiment not only have a stable surface and good performance as described above but also have high crack-proofness. For example, a BSG film even with 3 µm thick was free of crack.

Also, according to an embodiment of the invention, a film grows in an isotropic manner and therefore is very superior in step coverage.

As described above, Si-O-B bonds have been introduced as components as they are into as-depo BSG film 14 formed using a gas mixture consisting of a SiOB source and ozone (O₃). Therefore, as-depo BSG film 14 has a glass structure and hence high denseness and low hygroscopicity.

Further, the use of O₃ raises the resolvability of a SiOB source so that a BSG film 14 which has Si-O-B bonds just after deposition can be formed even when the wafer 1 under deposition is held at a low temperature below 400°C. Therefore, the method of the invention can be applied to semiconductor devices without restriction in a manufacturing process.

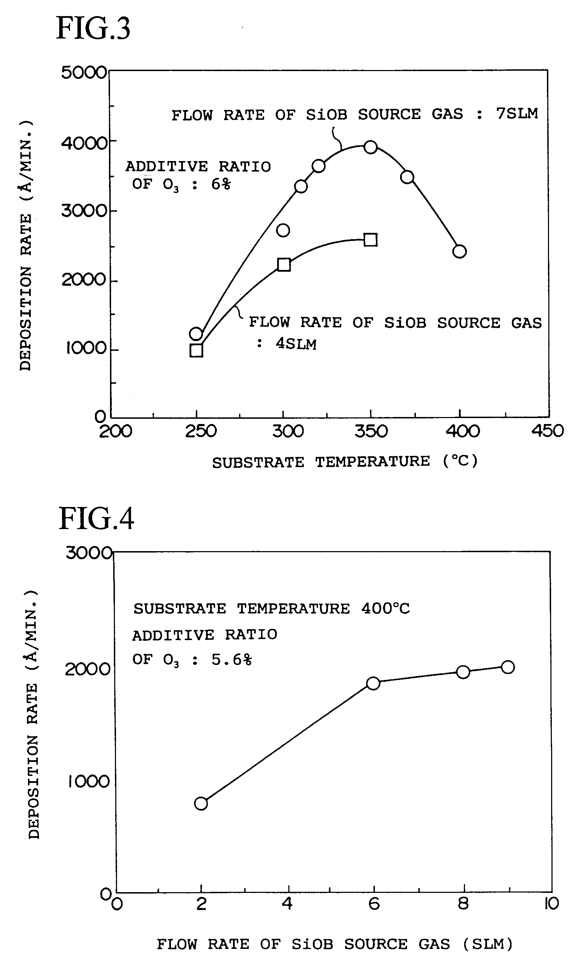

Referring to FIG. 3 and 4, deposition data on a BSG film formed by the deposition method described above are discussed.

FIG. 3 shows the dependence of the deposition rate upon the substrate temperature during deposition (depositing temperature). The axis of abscissa indicates the substrate temperature (°C) and the axis of ordinates indicates the deposition rate (Å/minute).

Here are shown experimental results on the dependence of the deposition rate upon the substrate temperature ranging from 250 through 400°C under two conditions that the flow rate of SiOB source gas is at 4 SLM and the additive ratio of O₃ is at 6 % and that the flow rate is at 7 SLM and the additive ratio is at 6 %, respectively.

According to the results, in case that the flow rate of SiOB source gas is at 7 SLM, the substrate temperature of 250°C yields a deposition rate of about 1000 Å/minute (hereinafter, expressed as "Å/min"), a higher temperature yields a higher deposition rate till the substrate temperature reaches 350°C to give the maximum deposition rate, 4000 Å/min, thereafter a much higher temperature yields a lower deposition rate, and the substrate temperature of 400°C gives a deposition rate of about 2500 Å/min. On the other hand, in case when the flow rate of SiOB source gas is 4 SLM, a similar tendency is shown and the maximum deposition rate of about 2600 Å/min is obtained at the substrate temperature of 350°C.

FIG. 4 is a characteristic diagram showing the dependence of the deposition rate upon the flow rate of SiOB source gas. The axis of abscissa indicates the flow rate of SiOB source gas (SLM) and the axis of ordinates indicates the deposition rate (Å/min).

Here is shown a experimental result on the dependence of the deposition rate on the flow rate of SiOB source gas ranging from 2 to 9 SLM under a condition that the depositing temperature is 400°C and the additive ratio of O₃ is 5.6 %.

According to the result, a deposition rate of about 800 Å/min is obtained at 2 SLM, the deposition rate increases keenly as the flow rate of SiOB source gas increases till the latter reaches 6 SLM to give a deposition rate of about 1900 Å/min, thereafter the deposition rate increases gradually as the flow rate increases, and about 2000 Å/min is obtained at 9 SLM.

Thus, it has been found that a method of the invention is sufficiently applicable to semiconductor devices by selecting suitable conditions on gas and substrate temperature (depositing temperature) according to the values shown in FIG. 3 and 4.

Besides, in the above embodiment the present invention is applied to a BSG film 14 formed using a gas mixture of ozone (O₃) and a SiOB source comprising [(CH₃)₃SiO]₃B, but it may be applied to a BSG film formed using other SiOB source. Also, the invention may be applied to a BSG film formed by any method other than the above described one. For example, the invention is applicable to a BSG film formed by a CVD technique using a gas mixture, TEOS+(TMB or TEB)+O₃ or a CVD technique using a gas mixture, SiH₄+B₂H₆+O₂.

Though an Al conductor layer has been used as a lower conductor layer 13, the invention is applicable to a conductor layer or an electrode comprising refractory metal, refractory metal silicide, polysillcon, polycide, or other conductor.

### (2) Characteristics of a BSG film reformed by the above described method for reforming an insulating film

(a) Investigations of the relative permittivity of a BSG film before and after reforming by the above described method for reforming an insulating film
   Results of investigations of the relative permittivity of a BSG film just after each of the above steps are shown as follows. (A BSG film was formed at 400°C by a CVD technique using a gas mixture consisting of SiOB source and O₃.)
   ε = 4.0 immediately after deposition.
   ε = 4.5 after exposure to the air.
   ε = 3.4 immediately after plasma treatment.
   ε = 3.6 after one-week exposure to the air after plasma treatment.

### ·Illustrative Comparisons

(1) In case of the SiO₂ film formed by thermal oxidation (without plasma treatment),
   ε = 4.0.
(2) In case of the SiO₂ film formed at 400°C by a CVD method using a gas mixture of TEOS and O₃,
   ε = 4.2 after exposure to the air, and
   ε = 4.0 after plasma treatment.

Thus, the relative permittivity of a BSG film obtained by a method for reforming according to an embodiment of the invention is considerably small as compared with that of other insulating films or that of the BSG film without plasma treatment. A plasma treatment enables the effect of reduction in the relative permittivity to last long.

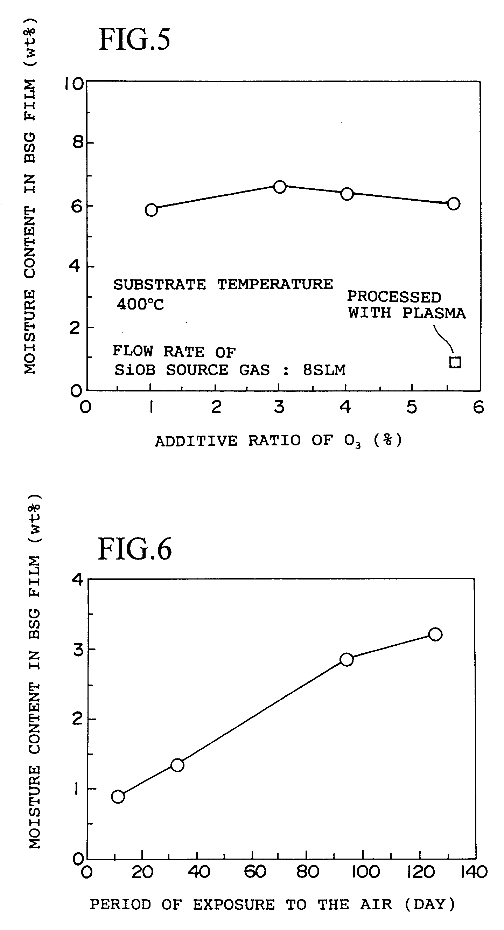

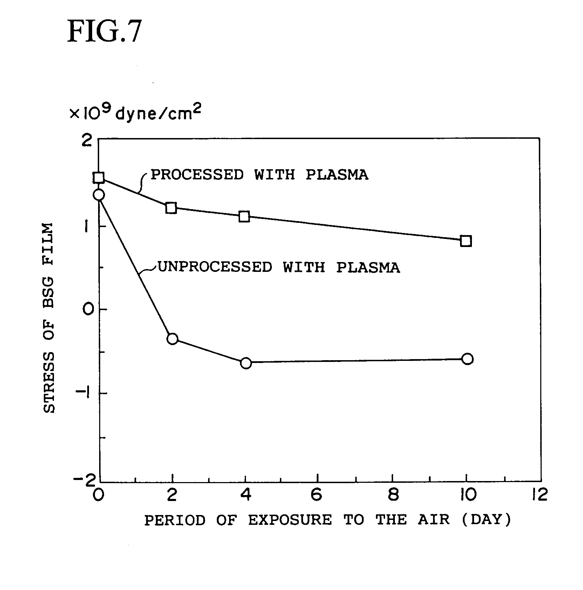

Therefore, the application of the invention to semiconductor devices enables a reduction of parasitic capacitance between conductor layers between which a BSG film intervenes.
(b) Investigations of the moisture content of a BSG film before and after reforming it by the above described method for reforming
   FIG. 5 is a characteristic diagram showing how the moisture content of the BSG film just after deposition depends on the additive ratio of O₃ in O₂ and showing the moisture content of the BSG film after plasma processing. The axis of abscissa indicates the additive ratio (%) of O₃ in O₂, and the axis of ordinates indicates the moisture content (wt%).
   In the following, there is shown a result in case when the depositing temperature is 400°C, the flow rate of source gas is 8 SLM and the additive ratio of O₃ ranges from 1 to 5.6 %. A sample was exposed to the air for 6 hours since deposition till measurement. And a BSG film deposited at an O₃ additive ratio of 5.6 % was processed with a plasma under a condition that a substrate temperature (a reforming temperature) is at 350°C, reforming gas is NH₃, a flow rate of reforming gas is at 400 SCCM, a gas pressure is at 0.5 Torr, an RF frequency is at 100 kHz, an RF power is at 200 W, and a process period is for 3 minutes.
   According to the result, the moisture content is about 6 wt% at an O₃ additive ratio of 1 %. The moisture content increases as the O₃ additive ratio increases till the latter reaches 3 % to yield the maximum moisture content of about 6.7 wt%, and thereafter the moisture content of the BSG film by SiOB hardly depends on the additive ratio of O₃, that is, it is constant. Additionally, a plasma treatment causes the moisture content to decrease sharply to 1 wt%. Thus, a plasma treatment improves the moisture content greatly resulting in improvement of characteristics and reliability of semiconductor device.
   Next, FIG. 6 is a characteristic diagram showing a change on standing in the moisture content of the BSG film processed with a plasma due to exposure to the air. The axis of abscissa indicates the exposure period of time (day) and the axis of ordinates indicates the moisture content (wt%).
   The following result was obtained through a depositing condition of deposition period for 3 minutes, a depositing temperature at 350°C, a deposition rate at 3700 Å/m with a source gas of a flow rate at 7 SLM and an O₃ additive ratio at 6 %, and through a plasma irradiating condition of a processing period for 3 minutes, a temperature at 350°C, a pressure at 0.5 Torr with an reforming gas NH₃ passed at a flow rate of 400 SCCM, and an RF power at 200 W with an RF frequency at 100 KHz.
   The moisture content becomes about 0.9 wt% after 10 days of exposure, thereafter increases in proportion to the elapsed time to reach 2.9 wt% after 96 days of exposure, subsequently increases gradually as time goes, and becomes 3.2 wt% after 125 days of exposure. The values show that a change on standing in the moisture content of the BSG film is very small as compared with that of a conventional method so that the effect of reforming lasts long.
(c) Investigations of a change on standing in stress of a BSG film obtained through the above described method for reforming
   FIG. 7 is a characteristic diagram showing a change on standing in stress in the BSG film due to exposure of the film to the air after plasma treatment. The axis of abscissa indicates the exposure period of time (day) and the axis of ordinates indicates the stress (x10⁹ dyne/cm²).
   The following result was obtained through a deposition for 3 minutes, at 350°C and a deposition rate at 3700 Å/min with a source gas at flow rate of 7 SLM and O₃ at an additive ratio of 6 %, and through a plasma irradiation for 3 minutes, at 350°C, at 0.5 Torr with an reforming gas NH₃ at 400 SCCM, and an RF power at 200 W with 100 KHz. For the purpose of comparison, also presented is a change on standing in stress of a BSG film which has not been yet reformed.
   As for a sample processed with a plasma, the tensile stress is approximately 1.5 (x10⁹ dyne/cm²) immediately after plasma processing, decreases gradually with the passage of time, and a tensile stress of 0.8 (x10⁹ dyne/cm²) remains after the passage of 10 days. On the other hand, as for a sample which is not processed with a plasma, a tensile stress of approximately 1.4 (x10⁹ dyne/cm²) remains immediately after plasma processing, but the stress changes largely for a short time to change from tensile stress to compressive one before the passage of 2 days and becomes a compressive stress of about 0.4 (x10⁹ dyne/cm²) after the passage of 2 days. Thereafter, the stress remains substantially unchanged with the passage of time and a compressive stress of about 0.6 (x10⁹ dyne/cm²) remains after the passage of 10 days. These values show that a plasma processing makes the change in stress small. This means the reduction of the moisture content of the film.

Thus, according to a method for reforming a BSG film according to an embodiment of the invention, the moisture content and hence the relative permittivity of a BSG film can be reduced by exposing the BSG film to a plasma of a reforming gas. Additionally, since absorption of moisture after film formation can be prevented, good performance of a film obtained through plasma processing can be maintained long.

Therefore, when the present invention is applied to a semiconductor device, parasitic capacitance between conductor layers between which a BSG film intervenes is reduced resulting in the improvement of characteristics and reliability.

Further, a plasma irradiation to a film on a substrate under the elevated temperature enlarges the effect of reforming film. Additionally, a low temperature below 500°C is good enough for reforming to make the invention applicable to processing of an interlayer insulating film covering Al etc.

## Claims

1. A method for reforming insulating film, comprising the steps of:
depositing a borosilicate glass film (14) on a substrate (1) using a depositing gas; and
exposing said borosilicate glass film (14) to a plasma gas.

2. The method defined in claim 1 characterized in that said plasma gas is at least one selected from a group consisting of an oxygen, an ammonia and an inert gas.

3. The method defined in claim 1 characterized in that said plasma is made by applying an RF power at a frequency from 100 KHz to 13.56 MHz and at 600 watts or lower to electrodes facing each other.

4. The method defined in claim 1 characterized in that said substrate is held at a temperature of 500°C or lower during exposing.

5. The method defined in claim 1 characterized in that said depositing gas includes an organic metal compound including Si-O-B bonds.

6. The method defined in claim 5 characterized in that said depositing gas is a gas mixture consisting of ozone (O₃) and said organic metal compound including Si-O-B bonds.

7. The method defined in claim 5 characterized in that said depositing gas is a gas mixture consisting of ozone (O₃), tetraethylorthosilicate (TEOS) and said organic metal compound including Si-O-B bonds.

8. The method defined in claim 5 characterized in that said organic metal compound including Si-O-B bonds is represented by a general formula:
[R¹₃-Si-O]ₙ-B-(OR²)₃₋ₙ
where n = 1, 2, 3, and each of R¹ and R² is selected from the group consisting of the alkyl group, aryl group and similar organic group.

9. The method defined in claim 1 characterized in that said substrate is held at a temperature of 400°C or lower during depositing.

10. The method defined in claim 1 characterized in that said depositing gas is a gas mixture consisting of trimethylboron (TMB), tetraethyl orthosilicate (TEOS) and ozone (O₃).

11. The method defined in claim 1 characterized in that said depositing gas is a gas mixture consisting of ozonetriethylboron (TEB), tetraethyl orthosilicate (TEOS) and ozone (O₃).

12. The method defined in claim 1 characterized in that said depositing gas is a gas mixture consisting of silane (SiH₄), diborane (B₂H₆) and oxygen (O₂).

13. The method defined in claim 1 characterized in that said borosilicate glass film is an insulating film between interconnection layers.

14. The method defined in claim 13 characterized in that one of said interconnection layers is one of an Al film and Al alloy film.
